# EUROPÄISCHE PATENTSCHRIFT

(11) **EP 3 141 336 B1**
(45) Veröffentlichungstag und Bekanntmachung des Hinweises auf die Patenterteilung: **16.01.2019**
(21) Anmeldenummer: 15405055.3
(22) Anmeldetag: 10.09.2015
(51) Int. Cl.: B23Q 1/01, B23Q 11/00, B23Q 1/38

(54) **POSITIONIERUNGSANORDNUNG**
POSITIONING ASSEMBLY
AGENCEMENT DE POSITIONNEMENT

(43) Veröffentlichungstag der Anmeldung: 15.03.2017
(73) Patentinhaber: Schneeberger Holding AG, 4914 Roggwil (CH)
(72) Erfinder: Vix, Martin, 4853 Riken (CH)
(74) Vertreter: EGLI-EUROPEAN PATENT ATTORNEYS

(56) Entgegenhaltungen:
- EP-A1- 2 564 982
- GB-A- 2 082 484
- JP-A- S60 238 709

## Beschreibung

Die Erfindung betrifft eine Werkstückpositionierungsanordnung, welche eine Positioniereinrichtung zum Positionieren eines Werkstücks sowie eine Entkopplungseinrichtung zur entkoppelten Lagerung der Positioniereinrichtung aufweist, wobei die Entkopplungseinrichtung ein Trägerelement, auf dem die Positioniereinrichtung angeordnet ist, und ein Basiselement, auf dem das Trägerelement gelagert ist, aufweist.

In vielen Gebieten der Technik wird zur Bearbeitung von zu bearbeitenden Werkstücken und/oder zur Inspektion von bereits bearbeiteten Werkstücken auf Bearbeitungsmaschinen bzw. Inspektionsmaschinen (oder allgemeiner: einer Prozessierungsanlage) zurückgegriffen, bei denen ein Werkzeugkopf bzw. ein Inspektionskopf relativ zum zu bearbeitenden bzw. zu inspizierenden Werkstück bewegt wird. Für die Durchführung einer Bearbeitung bzw. einer Inspektion (oder allgemeiner: einer Prozessierung) wird dabei entweder der Werkzeugkopf/Inspektionskopf mittels entsprechender Aktuatoren bewegt oder aber das Werkstück in einer beweglich angeordneten Werkstückaufnahme mittels Aktuatoren bewegt. Grundsätzlich ist es auch denkbar, dass sowohl der Werkzeugkopf/Inspektionskopf als auch das Werkstück bewegt werden. Die Bewegbarkeit bezieht sich dabei auf einen Maschinengrundkörper bzw. auf eine Werkstatt, Werkhalle oder dergleichen, in dem die Maschine aufgestellt ist.

In Fällen, in denen besonders kleine Strukturen prozessiert werden müssen (gefertigt und/oder inspiziert werden müssen), verwendet man üblicherweise das Grundprinzip, bei dem das betreffende Werkstück gegenüber einer stationären Basis bewegt wird. Dies beruht insbesondere auch auf Erwägungen hinsichtlich der jeweils vorliegenden Massen: das betreffende Werkstück weist in aller Regel eine vergleichsweise kleine Masse auf (auch wenn man die Masse der Werkzeugaufnahmevorrichtung und dergleichen mit einbezieht); der betreffende Werkzeugkopf/Inspektionskopf weist dagegen eine, insbesondere in Relation zum Werkstück, grosse Masse auf. Hierbei ist zu bedenken, dass für besonders kleine Strukturen typischerweise aufwändige Werkzeugköpfe/Inspektionsköpfe verwendet werden müssen, die eine ausreichende Präzision liefern; in aller Regel geht dies mit einer vergleichsweise grossen Baugrösse und/oder Masse einher. Ein Beispiel hierfür ist die Prozessierung von Halbleiterstrukturen (Halbleitermikrostrukturen), wie beispielsweise Mikroprozessoren, aber auch die Prozessierung mechanischer Mikrostrukturen.

Im Gebiet von Mikrostrukturen kommt dabei das zusätzliche Problem hinzu, dass bereits vergleichsweise kleine Vibrationen hinsichtlich ihrer Amplitude in der Grössenordnung der zu prozessierenden Strukturen liegen können, sofern keine geeigneten Gegenmassnahmen ergriffen werden. Naturgemäss sind derartige Vibrationen zu vermeiden, da diese das Werkstück unbrauchbar machen können bzw. unbrauchbare Messergebnisse resultieren können. Derartige Vibrationen können von aussen in das System eingetragen werden, etwa durch Erschütterungen durch vorbeilaufendes Bedienpersonal oder Vibrationen durch in der Nähe befindliche Maschinen. Um hier Vibrationen ausreichend zu verringern, werden typischerweise Entkopplungseinrichtungen verwendet, wie beispielsweise Dämpfungselemente, auf denen die eigentliche Prozessierungsanlage gelagert ist. Diese bewirken eine mechanische Entkopplung zwischen umgebendem Raum und prozessierender Maschine, zumindest innerhalb gewisser Grenzen.

Ein weiteres Problem sind Störungen, insbesondere Vibrationen, die durch die Prozessierungsanlage selbst erzeugt werden. Denn aufgrund der zu bewegenden Massen kommt es auch hier zu Beschleunigungsvorgängen bzw. Repositionierungsvorgängen von Massen, welche unvermeidbar zu mechanischen Vibrationen führen. Zudem können sich die dynamischen Reaktionskräfte von der Positioniereinrichtung über das Trägerelement auf das Basiselement und dessen Untergrund (Gestell, auf dem Basiselement gelagert ist, und Boden) übertragen, wobei dann das Basiselement und der Untergrund umgekehrt gemäss Actio = Reactio Gegenkräfte auf das Trägerelement und die Positioniereinrichtung ausüben. Insgesamt wird dadurch die Stabilität und Präzision der Positionierung nachteilig beeinträchtigt. Dieser Effekt kann mitunter sogar noch verstärkt werden, wenn zwischen Basiselement und Trägerelement aktive Stabilisierungseinrichtungen vorgesehen sind. Die zuvor beschriebenen Probleme treten mit zunehmenden Beschleunigungen bzw. Verfahrgeschwindigkeiten in gesteigertem Masse auf. Zum derzeitigen Zeitpunkt sind diese meist der limitierende Faktor bei einer Erhöhung der Prozessierungsgeschwindigkeit der Werkstücke. Dies ist problematisch, da geringere Bearbeitungsgeschwindigkeiten erhöhte Kosten bei der Herstellung der betreffenden Mikrostrukturen zur Folge haben. Besonders problematisch ist insbesondere der Fall, wenn aufgrund des technologischen Fortschritts kleinere Strukturen prozessiert werden sollen, beispielsweise neue Chipgenerationen mit verkleinerten Strukturgrössen.

Zur Verringerung von Vibrationen wurden im Stand der Technik bereits verschiedene Entkopplungsvorrichtungen vorgeschlagen. Ein Beispiel hierfür ist die japanische Offenlegungsschrift H2-201913A, in der eine von der Umgebung schwingungsentkoppelte Belichtungsvorrichtung vorgeschlagen wird. Ein optisches System kann mittels eines Bewegungsmittels relativ zu einem Tisch bewegt werden, auf dem das zu bearbeitende Werkstück befestigt wird. Zwischen dem Tisch und einem den Tisch (mitsamt dem optischen System) tragenden Sockel sind Lufthaltemittel vorgesehen. Lufthaltemittel befinden sich in einer horizontalen Ebene, die den Sockel vom Tisch trennen. Hierdurch wird eine Entkopplung in vertikaler Richtung bewirkt. Weiterhin ist ein Rahmen um den Tisch herum vorgesehen, wobei der Rahmen fest mit dem Sockel verbunden ist. Zwischen den seitlichen Rahmenwänden und den seitlichen Tischwänden sind ebenfalls Lufthaltemittel vorgesehen. Hierdurch kann eine verbesserte mechanische Entkopplung von Bewegungen realisiert werden, die parallel zu der horizontalen Ebene verlaufen. Insgesamt wird eine besonders gute Dämpfung und Schwingungsentkopplung in drei Dimensionen realisiert. Das Problem von Störungen, die durch hohe Verfahrgeschwindigkeiten bzw. hohe Beschleunigungen bei der Relativbewegung von Tisch und optischem System erzeugt werden, werden jedoch - sofern überhaupt - bestenfalls unzureichend angegangen.

Die EP 2 564 982 A1 beschreibt eine Bearbeitungsmaschine, welche einen Werkstückhalter und einen relativ dazu verfahrbaren Werkzeughalter umfasst, die jeweils auf einem Werkstückhalter-Träger bzw. einem Werkzeughalter-Träger translatorisch und/oder rotatorisch gelagert sind. Der Werkstückhalter-Träger und der Werkzeughalter-Träger sind über Federn oder Dämpfungslager elastisch miteinander gekoppelt, um Trägheitskräfte und starke Vibrationen des Gesamtsystems abzudämpfen.

Die Aufgabe der Erfindung besteht somit darin, eine Werkstückpositionierungsanordnung mit einer Positioniereinrichtung zum Positionieren eines Werkstücks sowie mit einer Entkopplungseinrichtung zur entkoppelten Lagerung der Positioniereinrichtung vorzuschlagen, bei der die Entkopplungseinrichtung ein Trägerelement, auf dem die Positioniereinrichtung angeordnet ist, und ein Basiselement, auf dem das Trägerelement gelagert ist, aufweist, welche gegenüber Werkstückpositionierungsanordnungen von diesem Typ, wie sie im Stand der Technik bekannt sind, verbessert ist.

Die vorliegende Erfindung löst diese Aufgabe. Es wird vorgeschlagen, eine Werkstückpositionierungsanordnung, welche eine Positioniereinrichtung zum Positionieren eines Werkstücks sowie eine Entkopplungseinrichtung zur entkoppelten Lagerung der Positioniereinrichtung aufweist und bei der die Entkopplungseinrichtung ein Trägerelement, auf dem die Positioniereinrichtung angeordnet ist, und ein Basiselement, auf dem das Trägerelement gelagert ist, aufweist, derart auszubilden, dass das Trägerelement zur Abkopplung von dynamischen Reaktionskräften der Positioniereinrichtung auf das Basiselement zumindest bereichsweise frei gleitend beweglich, bevorzugt im Wesentlichen frei von Gegenkräften, auf dem Basiselement gelagert ist. Bei der Positioniereinrichtung handelt es sich
typischerweise um eine Vorrichtung, welche aus grundsätzlich zwei Teilen aufgebaut ist. Dabei ist es möglich, dass ein zu prozessierendes Werkstück (Bearbeitung und/oder Inspektion) relativ zu einem Prozessierungssystem (Bearbeitungssystem, Bearbeitungskopf, Inspektionssystem, Inspektionskopf, Sensorkopf usw.) bewegbar ist. Typischerweise wird dabei das Werkstück auf einer Art Aufnahmetisch festgelegt und der Aufnahmetisch kann mittels Aktuatoren relativ zum Hauptkörper der Positioniereinrichtung, welche unter anderem auch das Prozessierungssystem aufweisen kann, bewegt werden. Rein beispielhaft kann es sich dabei um einen grundsätzlich im Stand der Technik bekannten Positioniertisch handeln. Derartige Positioniertische weisen üblicherweise einen stationären Teil (welcher in der Regel mechanisch mit der Prozessierungseinheit gekoppelt ist, insbesondere im Wesentlichen mechanisch starr gekoppelt ist) sowie einen bewegbaren Teil auf, wobei die Bewegung der beiden Einheiten relativ zueinander mittels Aktuatoren erfolgt. Aufgrund des Aufbaus mit der vorliegend vorgeschlagenen Entkopplungseinrichtung bewirkt eine Bewegung des bewegbaren Teils der Positioniereinrichtung aufgrund grundlegender physikalischer Gesetzmässigkeiten eine hierzu korrespondierende Gegenbewegung des stationären Teils der Positioniereinrichtung. Demzufolge ist der stationäre Teil der Positioniereinrichtung im Betriebszustand für einen aussenstehenden Beobachter nicht "stationär im eigentlichen Sinne". Stationär wäre der stationäre Teil der Positioniereinrichtung jedoch dann, wenn die Entkopplungseinrichtung beispielsweise abgeschaltet wird, sodass die freie Beweglichkeit des Trägerelements (und damit des stationären Teils der Positioniereinrichtung) gegenüber dem Basiselement nicht mehr gegeben ist (beispielsweise Ausschalten einer Pumpe für allfällige Fluidfilm-Lagerungseinrichtungen und dergleichen, soweit vorhanden). Obgleich typischerweise das Trägerelement und die Positioniereinrichtung (insbesondere der stationäre Teil der Positioniereinrichtung) zunächst voneinander unabhängige Baugruppen sind, die anschliessend in der Regel starr miteinander mechanisch gekoppelt werden, ist es Sinne der vorliegenden Erfindung auch möglich, dass der betreffende Teil der Positioniereinrichtung und das Trägerelement "von vornherein" als vormontierte, einheitliche Baugruppe, insbesondere als einteilige Baugruppe, gegebenenfalls auch als einstückige Baugruppe vorliegen. Gegebenenfalls kann insofern von einer kombinierten Trägerelement-Positioniereinrichtungsteil-Baugruppe (wobei insbesondere ein Teil des stationären Teils der Positioniereinrichtung bzw. der stationäre Teil der Positioniereinrichtung zu verstehen ist) gesprochen werden. Selbstverständlich sind auch andere Formulierungen denkbar.

Das Basiselement kann (mehr oder weniger) fest mit dem Boden, einer Wand oder dergleichen eines Raums verbunden werden, in dem die Werkstückpositionierungsanordnung aufgestellt werden soll. Möglich ist es dabei insbesondere, dass zwischen Basiselement und Boden/Wand und dergleichen weitere Entkopplungselemente bzw. Dämpfungselemente, wie sie grundsätzlich im Stand der Technik bekannt sind, vorgesehen werden. Insbesondere sind hierbei Elemente vorzusehen, die eine Dämpfung/Entkopplung in senkrechter Richtung (z-Achse) ermöglichen. In diesem Zusammenhang ist darauf hinzuweisen, dass die vorliegend vorgeschlagene Entkopplungseinrichtung typischerweise überwiegend bzw. (im Wesentlichen) ausschliesslich eine Entkopplung in horizontaler Richtung (x-y-Ebene) ermöglicht bzw. zur Verfügung stellt. Als grundsätzlich im Stand der Technik bekannte Entkopplungs-/Dämpfungseinrichtungen, welche in z-Richtung wirken, sind beispielsweise gasgefüllte Kissen, Stahlfedern, Gummielemente und dergleichen zu nennen. Im Übrigen ist es nicht schädlich, wenn allfällige, in z-Richtung dämpfende/entkoppelnde zusätzliche Dämpfungs-/Entkopplungsmittel auch eine Dämpfung/Entkopplung in x-y-Richtung zusätzlich zur vorliegend vorgeschlagenen Entkopplungseinrichtung bewirken.

Unter "dynamischen Reaktionskräften" sind insbesondere Kräfte zu verstehen, die aufgrund des Newton'schen Prinzips von Actio = Reactio entstehen. Wenn also ein bewegbarer Teil der Positioniereinrichtung relativ zum stationären Teil einer Positioniereinrichtung bewegt wird, so erfolgt eine (unter Berücksichtigung der jeweiligen Massenverhältnisse) gleichartige, jedoch entgegengesetzt wirkende Bewegung (bzw. Neigung zu einer Bewegung) des stationären Teils der Positioniereinrichtung. Dank der vorliegend vorgeschlagenen Entkopplungseinrichtung kann ein derartiger stationärer Teil der Positioniereinrichtung die beschriebene "Neigung zur Gegenbewegung" zumindest in gewissen Bereichen im Wesentlichen "voll in eine Gegenbewegung umsetzen". Es wird darauf hingewiesen, dass aufgrund des bei Positioniertischen üblichen Massenverhältnisses von bewegbarem zu stationärem Teil desselben das Trägerelement bei einem Betrieb der Werkstückpositionierungsanordnung oftmals in einem erstaunlich kleinen Bereich verbleibt. Dementsprechend ist es nicht erforderlich, dass das Basiselement eine besonders stark vergrösserte Oberfläche gegenüber der Grundfläche des Trägerelements aufweisen muss. Erfindungswesentlich ist dabei, dass die dynamischen Reaktionskräfte aufgrund der freien Beweglichkeit vollständig von dem Basiselement und dem Untergrund des Basiselements (beispielsweise das Gestell, auf dem das Basiselement gelagert ist, und/oder Boden) abgekoppelt sind, so dass das Basiselement und der Untergrund wiederum keine Gegenkräfte auf das Trägerelement und die Positioniereinrichtung ausüben können. Insgesamt wird dadurch eine hoch stabile und hoch präzise Positionierung mit hohen dynamischen Bewegungsabläufen ermöglicht.

Unter einer Beweglichkeit des Trägerelements gegenüber dem Basiselement sind insbesondere Translationsbewegungen und/oder Rotationsbewegungen zu verstehen, welche insbesondere in einer (im Wesentlichen) horizontalen Ebene erfolgen (also typischerweise parallel zur "oben liegenden" Oberfläche des Basiselement bzw. "unten liegenden" Oberfläche des Trägerelements). Mit der vorgeschlagenen Anordnung ist es auf vergleichsweise einfache Weise möglich, die Prozessierungsgeschwindigkeit des Werkstücks (Bearbeitung und/oder Inspektion) gegenüber bekannten Werkstückpositionierungsanordnungen zum Teil signifikant zu erhöhen. Dennoch kommt es typischerweise nicht zu einer Erhöhung der "aktuatorinduzierten Vibrationen". Hierdurch kann der Durchsatz an zu bearbeitenden Werkstücken zum Teil deutlich erhöht werden.

Eine vorteilhafte Ausführungsform der Werkstückpositionierungsanordnung ergibt sich, wenn das Trägerelement mittels eines Fluidfilms, insbesondere mittels eines Flüssigkeitsfilms, eines Schmiermittelfilms, eines Ölfilms, eines Gas-films und/oder eines Luftfilms auf dem Basiselement gelagert: ist, insbesondere frei schwimmend gelagert ist. Bei einer derartigen Ausführungsform ist die Verschiebung zwischen Trägerelement und Basiselement in der Regel besonders leichtgängig, sodass Gegenkräfte weitestgehend minimiert werden (wobei Gegenkräfte, insbesondere aufgrund von Reibung bzw. hydrodynamischen Bremsvorgängen, nie vollständig vermieden werden können). Aufgrund der geringen Reibung kann auch eine hohe Standzeit der Werkstückpositionierungsanordnung gewährleistet werden. Im Übrigen sind derartige Fluidfilme grundsätzlich im Stand der Technik bekannt, sodass zur Bereitstellung derselben im Zusammenhang mit der vorliegend vorgeschlagenen Werkstückpositionierungsanordnung auf kommerziell erhältliche Baugruppen zurückgegriffen werden kann, sodass die Kosten für die Werkstückpositionierungsanordnung verringert werden können.

Weiterhin wird vorgeschlagen, die Werkstückpositionierungsanordnung derart auszubilden, dass zwischen dem Trägerelement und dem Basiselement, vorzugsweise auf der dem Basiselement zugewandten Seite des Trägerelements und/oder auf der dem Trägerelement zugewandten Seite des Basiselements, eine oder mehrere Fluidfilm-Lagerungseinrichtungen, insbesondere Luftkissen-Lagerungseinrichtungen angeordnet sind. Insbesondere kann es sich hierbei um marktübliche Fluidfilm-Lagerungseinrichtungen handeln. Hierdurch kann ein besonders einfacher und/oder kostengünstiger Aufbau der Werkstückpositionierungsanordnung nochmals gefördert werden. Gegebenenfalls sind auch Wartungskosten infolge einer vereinfachten Austauschbarkeit der betreffenden Fluidfilm-Lagerungseinrichtungen realisierbar.

Eine weitere bevorzugte Ausbildungsform der Werkstückpositionierungsanordnung ergibt sich, wenn die Positioniereinrichtung einen stationären Teil und wenigstens einen relativ zum stationären Teil bewegbaren Teil aufweist, wobei bevorzugt das Verhältnis der Masse des wenigstens einen bewegbaren Teils der Positioniereinrichtung zur Gesamtmasse des Trägerelements und des stationären Teils der Positioniereinrichtung wenigstens 1/5, insbesondere wenigstens 1/10, bevorzugt wenigstens 1/20, besonders bevorzugt wenigstens ein 1/25 beträgt. Das Intervall soll dabei insbesondere zwischen Null und dem jeweiligen, genannten Wert liegen. Ein derartiger Aufbau bzw. derartige Werte werden oftmals von handelsüblichen Positioniertischen (gegebenenfalls nach üblicherweise geringfügigen Modifikationen) erreicht. Hierdurch wird ein kostengünstiger Aufbau der Anordnung weiter gefördert. Insbesondere bei Verwendung der genannten Massenverhältnisse ist darüber hinaus die durch physikalische Gesetzmässigkeiten bedingte "Gegenbewegung" des Trägerelements und/oder des stationären Teils der Positioniereinrichtung infolge von dynamischen Reaktionskräften vergleichsweise gering. Dadurch ist es insbesondere möglich, dass die Beschleunigungs-/Verfahrgeschwindigkeit des Trägerelements relativ zum Basiselement herabgesetzt wird, was in geringeren fluiddynamischen Gegenkräften bzw. geringeren Reibungskräften resultieren kann. Auch sind die Verschiebewege des Trägerelements vergleichsweise klein, sodass die vom Basiselement zur Verfügung zu stellende Grundfläche für das Trägerelement, auf der dieses frei beweglich angeordnet werden soll, nicht über Gebühr anwächst. Hierdurch kann Stellraum eingespart werden, aber auch Kosten, insbesondere für das Basiselement, können verringert werden.

Insbesondere wird vorgeschlagen, dass bei der Werkstückpositionierungsanordnung die Positioniereinrichtung dazu eingerichtet ist, das Werkstück entlang wenigstens einer linearen Achse (insbesondere x-Achse), insbesondere entlang wenigstens zweier linearen Achsen (insbesondere in einer x-y-Ebene liegend), bevorzugt entlang wenigstens dreier linearen Achsen (insbesondere x-y-z-Raumkoordinatensystem), besonders bevorzugt entlang wenigstens dreier linearen Achsen (insbesondere x-y-z-Raumkoordinatensystem) und um wenigstens eine Rotationsachse (insbesondere θ-Achse) zu positionieren. Dabei ist es möglich, dass die x-, y- und/oder z-Achse (teilweise) ein Orthogonalsystem bilden; jedoch ist auch die Verwendung eines (teilweisen) Nicht-Orthogonalsystems denkbar. Mit der vorgeschlagenen Ausführungsform ist es einerseits möglich, dass im Wesentlichen alle relevanten Prozessierungsvorgänge des Werkstücks realisiert werden können. Andererseits bewirkt eine Positionierung einer Werkstückpositionierungsanordnung von einem oder mehreren der vorgenannten Typen, dass die betreffende Positioniereinrichtung auf besonders vorteilhafte und effektive Weise mit der Entkopplungseinrichtung zusammenwirken kann, sodass die Werkstückpositionierungsanordnung die ihr immanenten Eigenschaften und Charakteristika in besonderer Weise zur Geltung bringen kann.

Weiterhin wird vorgeschlagen, die Werkstückpositionierungsanordnung derart auszubilden, dass das Trägerelement in wenigstens einer horizontalen Richtung (insbesondere x-Richtung), insbesondere in wenigstens zwei, vorzugsweise zueinander orthogonalen horizontalen Richtungen (insbesondere x-γ-Ebene), bevorzugt in allen horizontalen Richtungen, über einen Bereich von wenigstens 3 cm, insbesondere wenigstens 5 cm, bevorzugt wenigstens 10 cm, frei beweglich, bevorzugt im Wesentlichen frei von Gegenkräften, auf dem Basiselement gelagert ist. Obgleich es bevorzugt ist, dass zwei zueinander orthogonale horizontale Richtungen verwendet werden, sind auch hiervon abweichende, insbesondere nicht-orthogonale Koordinatensysteme denkbar. Die genannten Dimensionierungsangaben erweisen sich insbesondere dann als besonders vorteilhaft, wenn die vorab beschriebenen Massenverhältnisse und/oder der vorab vorgeschlagene Aufbau der Positioniereinrichtung verwendet werden. Die genannten Dimensionierungsangaben können insbesondere deshalb vorteilhaft sein, weil diese einen typischerweise besonders guten Kompromiss aus einfachem und kostengünstigem Aufbau (insbesondere möglichst kleine Fläche des Basiselements, was entsprechend kostensparend und stellflächensparend ist) und möglichst geringer Wahrscheinlichkeit für ein "Anstossen" des Trägerelements darstellen (also der Wahrscheinlichkeit dafür, dass die relative Verschiebbarkeit von Trägerelement und Basiselement im geometrischen Sinne nicht ausreichend weit durchgeführt werden kann und so beispielsweise Gegenkräfte ausgeübt werden müssen, damit das Trägerelement nicht vom Basiselement herunterrutscht, was zu schwerwiegenden Beschädigungen bis hin zur Zerstörung insbesondere der Positioniereinrichtung führen könnte).

Eine besonders bevorzugte Ausführungsvariante der Werkstückpositionierungsanordnung ergibt sich, wenn das Trägerelement zumindest in einem Minimalbereich gegenüber dem Basiselement beweglich, frei beweglich ist (also insbesondere verschiebbar und/oder drehbar ist), der sich aus einem maximalen Verfahrweg des wenigstens einen bewegbaren Teils der Positioniereinrichtung und dem Verhältnis der Masse des wenigstens einen bewegbaren Teils der Positioniereinrichtung zur Gesamtmasse des Trägerelements und des stationären Teils der Positioniereinrichtung ergibt. Die hierzu erforderlichen Berechnungen beruhen auf elementaren physikalischen Erwägungen und Formeln der Bewegungsgleichung. Sie sind ohne weiteres vom Fachmann, der eine Werkstückpositionierungsanordnung konstruieren soll, durchführbar. Mit der vorgeschlagenen Ausbildung ist es ebenfalls möglich, den vorab genannten guten Kompromiss aus möglichst geringer Dimensionierung insbesondere der Oberfläche des Basiselements und der möglichst geringen Wahrscheinlichkeit für das Auftreten von Gegenkräften (beispielsweise um ein Herunterrutschen des Trägerelements vom Basiselement zu vermeiden) zu realisieren. Dies ist insbesondere auch bei eher "untypischen" Positioniereinrichtungen möglich (also insbesondere Positioniereinrichtungen, die von ihrem Aufbau her von typischen, kommerziell erhältlichen Positioniereinrichtungen abweichen).

Weiterhin wird vorgeschlagen, dass bei der Werkstückpositionierungsanordnung wenigstens eine Begrenzungseinrichtung zur Begrenzung der freien Bewegbarkeit zwischen Basiselement und Trägerelement vorgesehen wird. Hierbei kann es sich beispielsweise um eine einfache "Bande" (also eine Art Rahmenelement) handeln. Denkbar sind jedoch auch mechanisch wirkende Bauteile (wie beispielsweise Federn) oder aber auch gegebenenfalls aktiv gesteuerte Komponenten, die die freie Bewegbarkeit begrenzen können (Einschalten eines zum Beispiel pneumatischen Aktuators, sofern ein gewisser Bewegungsbereich verlassen wird oder dergleichen). Mit einer derartigen Begrenzungseinrichtung kann auf einfache und effektive Weise vermieden werden, dass beispielsweise das Trägerelement vom Basiselement herunterrutscht, was zu schweren, gegebenenfalls auch zu irreparablen Schäden, insbesondere der Positioniereinrichtung, führen kann. Die Begrenzungseinrichtung sollte dabei derart ausgestaltet und eingerichtet und/oder insbesondere von ihrer Dimensionierung her derart auf die Werkstückpositionierungsanordnung angepasst sein, dass diese möglichst selten "eingreifen muss", was insbesondere für typische Bearbeitungszyklen gelten soll.

Als vorteilhafte Weiterbildung wird vorgeschlagen, dass die zumindest eine Begrenzungseinrichtung der Werkstückpositionierungsanordnung als vorzugsweise weich eingreifende Begrenzungseinrichtung ausgebildet ist und/oder die Begrenzungseinrichtung eine vorzugsweise weich eingreifende Anschlageinrichtung, insbesondere eine Federeinrichtung, eine Luftkisseneinrichtung und/oder eine Fluiddämpfungseinrichtung, aufweist und/oder wenigstens eine in eine vorzugsweise horizontale Richtung wirkende, besonders vorzugsweise weich eingreifende Feder aufweist, die zwischen Trägerelement und Basiselement angeordnet ist. Dabei ist die Begrenzungseinrichtung bzw. Feder derart "weich eingreifend" (etwa mit einer derart kleinen Federkonstante) ausgebildet, dass das Trägerelement zumindest bereichsweise immer noch im Wesentlichen frei von Gegenkräften beweglich auf dem Basiselement gelagert ist. Hierdurch ist es insbesondere möglich, dass harte Stösse, welche insbesondere auf die Positioniereinrichtung einwirken könnten, weitestgehend vermieden werden. Hierdurch kann insbesondere die Standzeit der Positioniereinrichtung nochmals erhöht werden. Auch können hierdurch Schläge "nach aussen hin" (welche insbesondere über das Basiselement auf einen Fussboden oder eine Wand übertragen werden könnten), die dort nachteilige Effekte zeigen könnten, weitgehend vermieden werden. Gegebenenfalls ist es durch eine weich eingreifende Begrenzungseinrichtung möglich, dass in Grenzfällen, in denen gewissermassen das Eingreifen der Begrenzungseinrichtung "gerade eben" erforderlich ist, das Eingreifen derselben nicht einmal zu einem Fehler bei der Prozessierung des Werkstücks führen muss. Dies ist natürlich besonders vorteilhaft, da hierdurch Ausschuss bzw. wiederholte Prozessierungsvorgänge vermieden werden können.

Weiterhin wird vorgeschlagen, dass bei der Werkstückpositionierungsanordnung das Trägerelement und/oder das Basiselement als massiver Körper, insbesondere als Metallkörper, Eisenkörper, Gusseisenkörper, Mineralgusskörper, Stahlkörper, Steinblock, Marmorblock, Basaltblock und/oder Granitblock, ausgebildet ist. In ersten Versuchen hat sich ergeben, dass ein derartiger Aufbau bzw. dass derartige Materialien besonders vorteilhaft sind. Darüber hinaus sind die genannten Materialien bzw. ist der genannte Aufbau tendenziell handelsüblich, was vorteilhaft ist (insbesondere auch unter Kostengesichtspunkten).

Weiterhin wird vorgeschlagen, dass das Basiselement der Werkstückpositionierungsanordnung eine dem Trägerelement zugewandte, vorzugsweise horizontal ausgerichtete Lagerungsfläche aufweist. Mit einem derartigen Aufbau kann die vorgeschlagene Abkopplung von dynamischen Reaktionskräften auf besonders einfache und effektive Weise realisiert werden. Darüber hinaus entspricht der vorgeschlagene Aufbau dem typischen Aufbau handelsüblicher Basiselemente, was entsprechende Vorteile mit sich bringt.

Eine weitere bevorzugte Weiterbildung der Werkstückpositionierungsanordnung ergibt sich, wenn diese zumindest ein Nullstellungsmittel aufweist, das dazu ausgebildet und eingerichtet ist, insbesondere in einem Ruhezustand der Positioniereinrichtung das Trägerelement in eine definierte Nullstellungsposition und/oder in einen definierten Nullstellungspositionsbereich gegenüber dem Basiselement zu bringen. Bei dem Nullstellungsmittel kann es sich sowohl um aktive als auch um passive Nullstellungsmittel handeln. Insbesondere bei einer aktiven Ausführung des Nullstellungsmittels ist es möglich, dass dieses dann "angeschaltet wird" (also eine Wirkung entfaltet), wenn gerade kein Prozessierungsvorgang erfolgt. Hierdurch kann eine gesicherte Nullstellung der Werkstückpositionierungsanordnung sichergestellt werden, ohne dass dies nachteilige Effekte auf die zu prozessierenden Werkstücke hat. Der Nullstellungsvorgang kann dann auch (vergleichsweise) schnell erfolgen. Zusätzlich oder alternativ bietet sich auch die Verwendung von passiven Nullstellungsmitteln an. Insbesondere passive Nullstellungsmittel können von ihrem Aufbau her besonders einfach sein. Die Nullstellungskräfte der passiven Nullstellungsmittel können dabei typischerweise "immer" auftreten (insbesondere sofern die Nullstellungsposition bzw. der Nullstellungspositionsbereich verlassen ist), also auch dann, wenn eine Prozessierung eines Werkstücks erfolgt. Typischerweise werden die Nullstellungskräfte jedoch vergleichsweise klein gewählt, sodass diese typischerweise gegenüber den sonstigen auftretenden Kräften gering, insbesondere (im Wesentlichen) vernachlässigbar sind. Wesentlich ist dabei meist nur, dass die Nullstellungskräfte so gewählt werden, dass diese (unter normalen Betriebsbedingungen) keine (signifikanten) nachteiligen Effekte auf die Prozessierung des Werkstücks haben. Die Nullstellung kann sich dabei auf eine oder mehrere Translationsrichtungen und/oder auf eine oder mehrere Rotationsrichtungen beziehen. Mit einem Nullstellungsmittel ist es insbesondere möglich, dass das Trägerelement tendenziell immer die "maximal zur Verfügung stehenden" Ausgleichsbewegungen relativ zum Basiselement ausüben kann, sodass insbesondere das Ansprechen einer Begrenzungseinrichtung (falls überhaupt) nur besonders selten erfolgen muss.

Besonders vorteilhaft ist es dabei, wenn das zumindest eine Nullstellungsmittel als Federeinrichtung, als Schiefflächeneinrichtung und/oder als aktiv ansteuerbare Aktuatoreinrichtung ausgebildet ist. Bei der Federeinrichtung kann es sich beispielsweise um (eine Anordnung von) Federn handeln (metallische Federn und/oder Spiralfedern oder dergleichen), welche eine vergleichsweise geringe Rückstellkraft aufweisen (beispielsweise kleine Federkonstante). Eine Schiefflächeneinrichtung ist typischerweise derart ausgebildet, dass diese eine stabile Nullpunktlage aufweist. Dies kann beispielsweise durch eine leicht konkave Ausbildung des Basiselements realisiert werden. Da die Nullstellungskräfte typischerweise nur gering sind, ist eine typischerweise geringe Kurvatur in aller Regel ausreichend, sodass in aller Regel keine nachteiligen Effekte einhergehen (beispielsweise teilweises Aufsetzen des Trägerelements auf dem Basiselement oder dergleichen) .

Weiterhin wird vorgeschlagen, dass bei der Werkstückpositionierungsanordnung zumindest eine Werkstückprozessierungseinrichtung, insbesondere eine Werkstückbearbeitungseinrichtung und/oder zumindest eine Werkstückinspektionseinrichtung, vorgesehen ist, wobei die Werkstückprozessierungseinrichtung, Werkstückbearbeitungseinrichtung bzw. Werkstückinspektionseinrichtung bevorzugt auf dem Trägerelement angeordnet ist und insbesondere vorzugsweise starr mit diesem mechanisch gekoppelt ist. Insbesondere im Rahmen der vorliegenden Anmeldung ist eine Werkstückprozessierungseinrichtung als Oberbegriff zu einer Werkstückbearbeitungseinrichtung und/oder einer Werkstückinspektionseinrichtung zu verstehen. Dementsprechend ist auch eine Prozessierung als Oberbegriff zu einer Bearbeitung und/oder Inspektion zu verstehen. Mit dem vorliegend vorgeschlagenen Aufbau der Werkstückpositionierungsanordnung können insbesondere "aktuatorinduzierte Eigenvibrationen" verhindert werden. Darüber hinaus ergibt sich in der Regel eine für die Werkstückpositionierungsanordnung besonders vorteilhafte Massenverteilung aus beweglichem Teil der Positioniereinrichtung und stationärem Teil der Positioniereinrichtung einschliesslich des Trägerelements. Darüber hinaus ist der vorgeschlagene Aufbau typisch für handelsüblich erhältliche Positioniertische, sodass diese auch für die vorgeschlagene Werkstückpositionierungsanordnung verwendet werden können (gegebenenfalls nach meist vergleichsweise geringfügigen Anpassungen).

Besonders vorteilhaft ist es, wenn die Werkstückpositionierungsanordnung als Werkstückpositionierungsanordnung zur Prozessierung, Bearbeitung, Belichtung und/oder Inspektion von Halbleiterstrukturen, Mikrostrukturen, Nanostrukturen und/oder Wafern als Werkstück ausgebildet und eingerichtet ist. In einem derartigen Fall können die der Werkstückpositionierungsanordnung intrinsischen Eigenschaften und Vorteile in besonderem Masse zur Geltung kommen.

Weitere Einzelheiten der Erfindung und insbesondere beispielhafte Ausführungsformen der vorgeschlagenen Vorrichtung und des vorgeschlagenen Verfahrens werden im Folgenden anhand der beigefügten Zeichnungen erläutert. Es zeigen:
- Fig. 1a: ein erstes Ausführungsbeispiel für eine Werkstückpositionierungsanordnung mit gleitend angeordnetem Prozessierungstisch in einer schematischen Explosionsansicht;
- Fig. 1b: Seitenansicht der Werkstückpositionierungsanordnung gemäss Fig. 1a;
- Fig. 1c: Draufsicht der Werkstückpositionierungsanordnung gemäss Fig. 1a;
- Fig. 2a: ein zweites Ausführungsbeispiel für eine Werkstückpositionierungsanordnung mit gleitendem Prozessierungstisch in einer schematischen Explosionsansicht;
- Fig. 2b: Seitenansicht der Werkstückpositionierungsanordnung gemäss Fig. 2a;
- Fig. 2c: Draufsicht der Werkstückpositionierungsanordnung gemäss Fig. 2a.

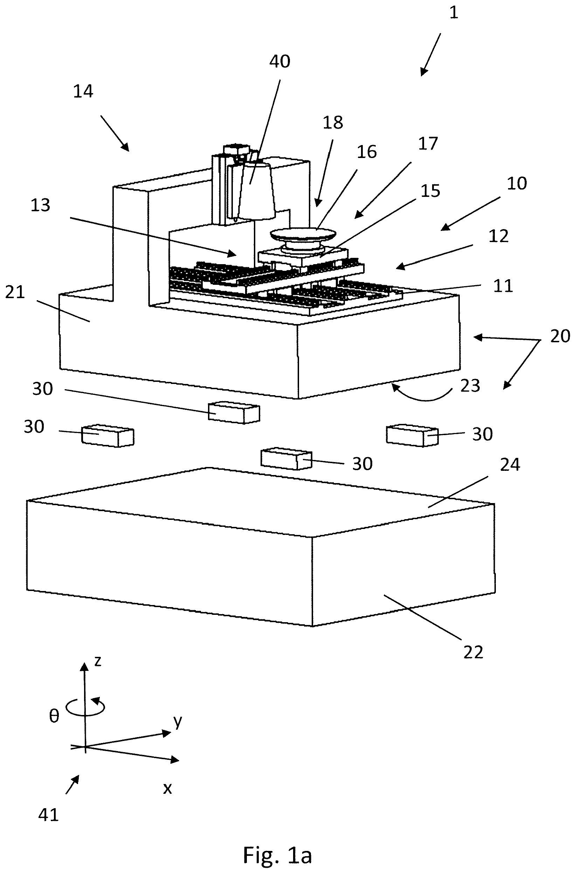

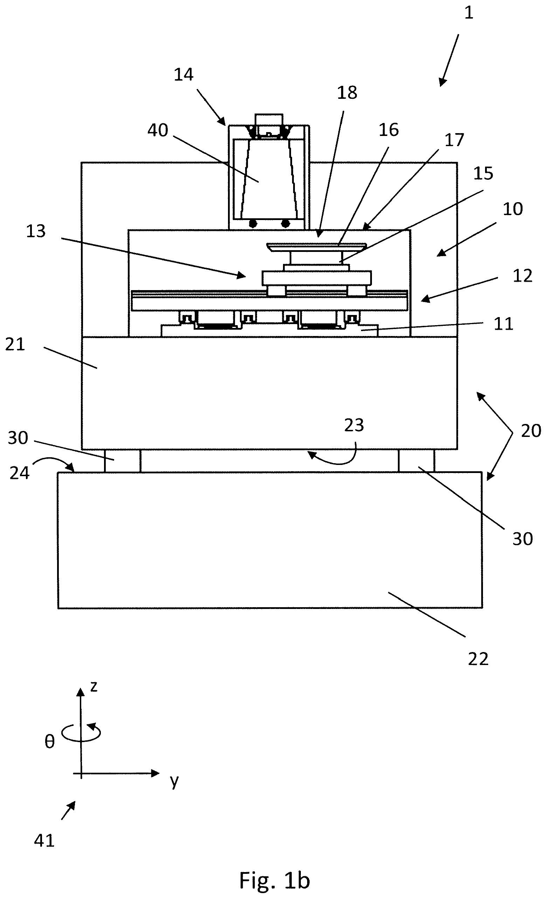

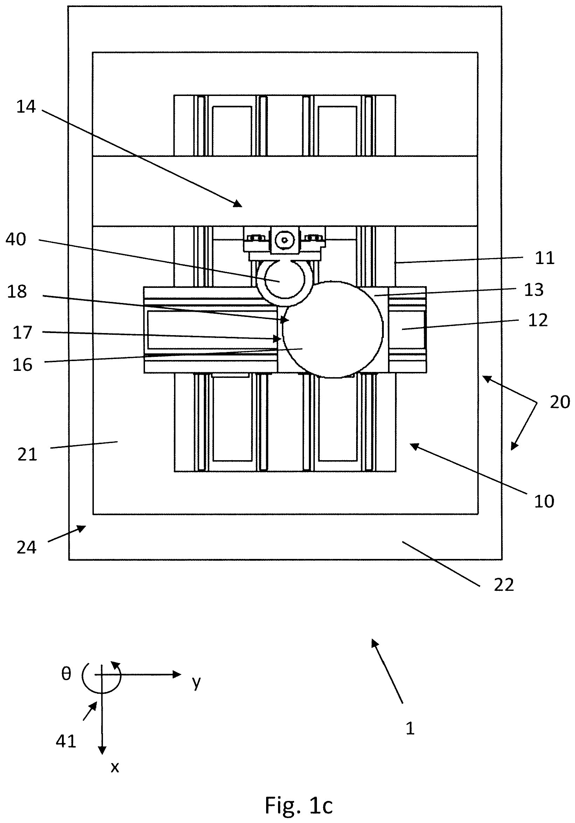

In den Fig. 1a-1c ist ein erstes mögliches Ausführungsbeispiel für einen Prozessierungstisch 1, beispielsweise für Halbleitermikrostrukturen oder sonstige Werkstücke, in einer schematischen Explosionsansicht dargestellt.

Zur eigentlichen Prozessierung dient der Positioniertisch 10, der von seinem grundsätzlichen Aufbau her im Wesentlichen einem Positioniertisch entspricht, wie er im Stand der Technik üblich ist und auch industriell verbreitet eingesetzt wird. Der Positioniertisch 10 weist einen Sockel 21 auf, der üblicherweise eine vergleichsweise grosse Masse aufweist. Der Sockel 21 dient zur Befestigung der "eigentlichen" stationären Platte 11 des Positioniertischs 10, welche beispielsweise Führungsschienen bzw. Verfahrschienen für einen verfahrbaren Schlitten aufweist. Weiterhin ist am Sockel 21 ein Tragarm 14 mechanisch starr befestigt, an dem wiederum ein Prozessierungskopf 40 mechanisch starr befestigt ist. Demzufolge bilden Sockel 21, Tragarm 14, Positionierungskopf 40 und stationäre Platte 11 des Positioniertischs 10 eine mechanisch miteinander gekoppelte Baugruppe, bei der sich keine Teile gegeneinander bewegen. Dies schliesst selbstverständlich nicht aus, dass insbesondere im Prozessierungskopf 40 bzw. im Sockel 21 Bauteile aufgenommen sind, die gewisse Bewegungen relativ zum "stationären Sockelsystem" 11, 21, 40 durchführen.

Der Sockel 21 kann zur Aufnahme weiterer Bauelemente dienen, wie insbesondere zur Aufnahme von Aktuatoren und Steuerungselektronik (Einplatinencomputer, Controller und dergleichen, Sensorik usw.). Auch im Prozessierungskopf 40 können sich unterschiedlichste (Unter-)Baugruppen befinden, wie insbesondere Baugruppen, die der Prozessierung eines Werkstücks dienen (also Bearbeitung, Überprüfung, Messung, Strukturierung, Belichtung usw.).

Auf der stationären Platte 11 sind zwei verfahrbare Schlitten 12, 13 (erster verfahrbarer Schlitten 12 und zweiter verfahrbarer Schlitten 13) angeordnet, die mittels entsprechender Aktuatoren (beispielsweise Linearmotoren) in jeweils eine Richtung bewegt werden können. Der erste verfahrbare Schlitten 12 kann dabei linear in einer geradlinigen Translationsrichtung (x-Richtung) relativ zur stationären Platte 11 bewegt werden. Dazu ist der erste verfahrbare Schlitten 12 direkt verschieblich an der stationären Platte 11 angeordnet. Der zweite verfahrbare Schlitten 13 (y-Richtung) ist linear verschieblich (Translationsbewegung) am ersten verfahrbaren Schlitten 12 angeordnet. Der zweite verfahrbare Schlitten 13 ist somit nur mittelbar/indirekt mit der stationären Platte 11 verbunden. Durch die Übereinanderlagerung zweier linearer (Translations-)Bewegungen (wobei vorliegend die x- und die y-Achse zueinander orthogonal stehen; siehe auch die Koordinatenachsen 41, die zur Verdeutlichung der Verhältnisse in den Fig. 1a-1c eingezeichnet sind) kann eine Bewegung des zu prozessierenden Werkstücks (zunächst) in einer horizontal liegenden x-y-Ebene durchgeführt werden.

Auf dem zweiten verfahrbaren Schlitten 13 wiederum ist als weitere Komponente des Positioniertischs 10 ein Drehtisch 17 angeordnet, wobei die Drehtischbasis 15 am zweiten verfahrbaren Schlitten 13 mechanisch starr befestigt ist. Der Drehteller 16 des Drehtischs 17 kann durch einen Stellmotor (nicht dargestellt) gegenüber der Drehtischbasis 15 verdreht werden (Drehbewegung in θ-Richtung/siehe Koordinatensystem 41) .

Ein auf dem Drehteller 16 bzw. in einer Werkstückaufnahme 18 angeordnetes Werkstück kann somit zusätzlich zu einer Verschiebung in der x-y-Ebene auch in eine Richtung θ gedreht werden (jeweils insbesondere relativ zum Prozessierungskopf 40). Eine derartige Verstellbarkeit ist für viele Anwendungen ausreichend (insbesondere bei der Halbleiterstrukturierung). Eine gegebenenfalls notwendige "Tiefenvariation" (welcher Art auch immer) kann - sofern erforderlich - durch entsprechende Anpassung der im Prozessierungskopf 40 angeordneten Prozessierungsbaugruppen erfolgen. Dementsprechend kann der eigentliche Werkstückaufnahmebereich 18 (auf dem Drehteller 16) beim vorliegend in den Fig. 1a-1c dargestellten Ausführungsbeispiel eines Prozessierungstischs 1 nicht in z-Richtung verstellt werden.

Der Sockel 21 des Positioniertischs 10 wird frei gleitend verschiebbar auf einem Basistisch (Basiselement) 22 angeordnet. Der Basistisch 22 besteht beispielsweise aus einer polierten Granitplatte (wobei auch andere Materialien denkbar sind). Der Basistisch 22 wiederum ist beispielsweise über Stellfüsse und weitere Dämpfungselemente (beispielsweise gasgefüllte Kissen und dergleichen) in einem Raum aufgestellt. Hierbei kann es sich beispielsweise um eine Werkstatt, ein Labor, einen Reinraum bzw. eine Fertigungshalle einer Fabrik handeln.

Um die frei gleitende Verschiebbarkeit des Positioniertischs 10 und des Sockels 21 gegenüber dem Basistisch 22 zu ermöglichen, sind zwischen der Unterseite 23 (unten liegende Oberfläche) des Sockels und der Oberseite 24 (oben liegende Oberfläche) des Basistischs 22 mehrere Luftkissenlager 30 (vorliegend vier Luftkissenlager 30) vorgesehen. Damit die Luftkissenlager 30 in einer "sinnvollen Position" verbleiben (also insbesondere nicht seitlich aus dem Zwischenraum zwischen Sockel 21 und Basistisch 22 heraus wandern), können diese beispielsweise am Basistisch 22 oder am Sockel 21 befestigt werden. Bevorzugt ist hierbei die Anordnung am Sockel 21, da die Fläche, die der Sockel 21 einnimmt, typischerweise geringer ist als die Oberseite 24 des Basistischs 22, die der Unterseite 23 des Sockels 21 zugewandt ist.

Durch die frei gleitende Beweglichkeit (Verschiebbarkeit und/oder Verdrehbarkeit) mittels der Luftkissenlager 30 wird verhindert, dass Vibrationen des Positioniertischs 10 über den Basistisch 22 in die Umgebung geleitet werden können, wo diese gegebenenfalls bei anderen Maschinen Probleme erzeugen können oder wieder in das System zurückgekoppelt werden können. Umgekehrt kann natürlich auch verhindert werden, dass externe Vibrationen über den Basistisch 22 in den Positioniertisch 10 eingeleitet werden. Derartige Vibrationen können beispielsweise durch benachbart aufgestellte Maschinen, einen vorbeilaufenden Mitarbeiter, durch in der Nähe vorbeifahrende Fahrzeuge, durch Stürme oder dergleichen erzeugt werden. Zudem wird durch die frei gleitende Beweglichkeit (Verschiebbarkeit und/oder Verdrehbarkeit) mittels der Luftkissenlager 30 verhindert, dass Vibrationen des Positioniertischs 10 in den Basistisch 22 und durch Rückkopplung wieder zurück in den Positioniertisch 10 geleitet werden können.

Es ist darauf hinzuweisen, dass bei einem Betrieb des Positioniertischs 10 durch die Bewegung (Verschiebung und/oder Drehung) der Werkstückaufnahme 18 (auf dem Drehteller 16 des Drehtischs 17 befindlich) Massen bewegt werden. Bei einer Drehung des Drehtischs 17 um die Achse θ wird eine Masse bewegt, die der Summe der Masse aus dem zu bearbeitenden Werkstück und dem Drehteller 16 (einschliesslich Werkstückaufnahme 18) entspricht. Wird der zweite Schlitten 13 in y-Richtung bewegt, wird eine Masse bewegt, die der Summe der Masse aus Werkstück, Drehtisch 17 (einschliesslich Werkstückaufnahme 18) und zweitem verfahrbaren Schlitten 13 entspricht. Wird der erste verfahrbare Schlitten 12 bewegt, wird eine Masse bewegt, die der Summe der Masse aus Werkstück, Drehtisch 17 (einschliesslich Werkstückaufnahme 18), zweitem verfahrbaren Schlitten 13 und erstem verfahrbaren Schlitten 12 entspricht. Der Vollständigkeit halber wird darauf hingewiesen, dass bei einer "Bewegung" natürlich auch entsprechende Beschleunigungs- und Abbremsvorgänge der jeweiligen bewegten Massen auftreten. Aufgrund des Newton'schen Gesetzes bedingt die Bewegung der betreffenden Massen eine entsprechende Gegenbewegung der verbleibenden Massen des Positioniertischs 10. Demzufolge kommt es zu gewissen Bewegungen des Sockels 21 des Positioniertischs 10, die den Bewegungen des Werkstücks/der Werkstückaufnahme 18 entgegengesetzt sind. Aufgrund der unterschiedlichen Massen ("verbleibende Massen" sind in der Regel deutlich grösser als die jeweiligen bewegten Massen) sind jedoch die Wege, die der Sockel 21 zurücklegt, typischerweise deutlich kleiner. Wenn also beispielsweise das Werkstück/die Werkstückaufnahme 18 um 10 cm verschoben wird, so hat dies eine Verschiebung des Sockels 21 um lediglich 1 cm zur Folge (um beispielhaft typische Werte zu nennen).

Die Bewegung des Sockels 21 erfolgt dabei frei gleitend-verschieblich (einschliesslich der Möglichkeit von Drehbewegungen) gegenüber dem Basistisch 22.

Weiterhin wird darauf hingewiesen, dass sich bei einer typischen Bearbeitung eines Werkstücks die Bewegungen des Werkstücks gewissermassen im Mittel ausgleichen (typischerweise erfolgt eine schnelle Bewegungsabfolge des Werkstücks bzw. der Werkstückaufnahme 18). Das hat aber zur Folge, dass sich die Bewegungen des Sockels 21 des Positioniertischs 10 relativ zum Basistisch 22 ebenfalls "im Mittel ausgleichen". Demzufolge kann der "überschüssige Rand" des Basistischs 22 gegenüber dem Sockel 21 (vergrösserte Fläche der Oberseite 24 des Basistischs 22 gegenüber der Fläche der Unterseite 23 des Sockels 21) vergleichsweise klein sein. Typischerweise sind überstehende Ränder im Bereich von 5 cm, 10 cm oder 20 cm für normale Betriebsbedingungen völlig ausreichend.

Obgleich dies aufgrund der geringen Verformung der Oberseite 24 (oben liegenden Oberfläche) des Basistischs 22 in den Fig. 1a-1c nicht zu erkennen ist, weist die Oberseite 24 des Basistischs 22 beim vorliegend dargestellten Ausführungsbeispiel eine leicht konkave Form auf (schüsselartige Formgebung). Dies hat zur Folge, dass gewisse Rückstellkräfte vorhanden sind (auch wenn diese gegenüber den auftretenden Beschleunigungskräften bzw. Beschleunigungs-Gegenkräften infolge einer Bewegung eines Werkstücks/der Werkstückaufnahme 18 vergleichsweise klein sind), die den Sockel 21/den Positioniertisch 10 in eine definierte Null-Lage zurückzubewegen versuchen (stabiles Gleichgewicht infolge potentieller Energie). Möglich ist es natürlich auch, dass die Oberseite 24 des Basistischs 22 eine in der Mitte liegende ebene, horizontal ausgerichtete Fläche aufweist und in Randbereichen des Basistischs 22 leicht ansteigende Bereiche vorgesehen werden (Hohlraum nach Art eines Pyramidenstumpfes, dessen "Spitze" nach unten zeigt). In einem derartigen Fall wird ein gewisser Null-Lagebereich realisiert. Befindet sich der Positioniertisch 10 in diesem Null-Lagebereich, befindet er sich in einem indifferenten Gleichgewicht; verlässt er den Null-Lagebereich, entsteht eine Neigung, den Positioniertisch 10 in den Null-Lagebereich zurückzubringen.

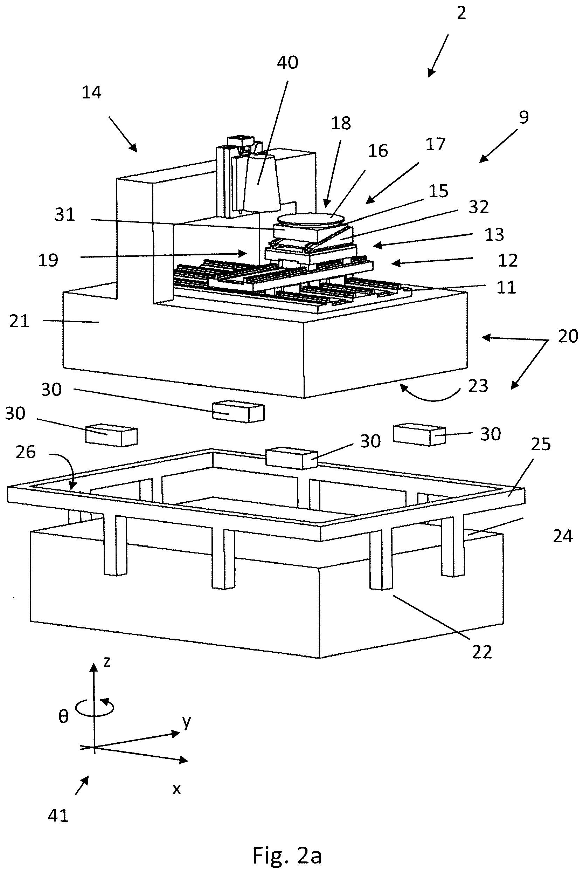

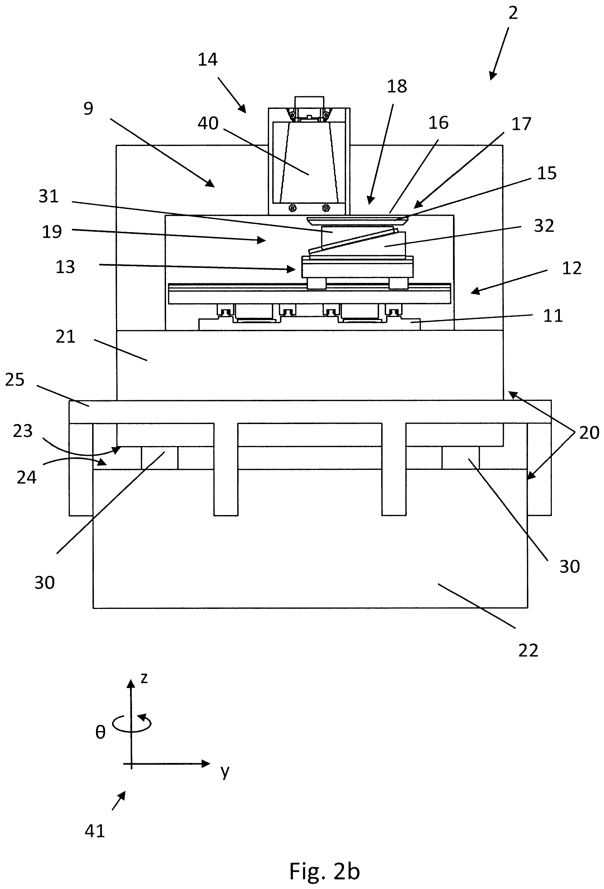

In den Fig. 2a-2c ist ein zweites mögliches Ausführungsbeispiel für einen Prozessierungstisch 2 dargestellt. Ein grösserer Anteil der Baugruppen des vorliegend dargestellten Prozessierungstischs 2 entspricht denen des in den Fig. 1a-1c dargestellten Prozessierungstischs 1. Aus Gründen der besseren Verständlichkeit werden daher für gleichartige Baugruppen identische Bezugszeichen verwendet. Dies impliziert jedoch nicht, dass die Baugruppen zwangsweise "vollständig identisch" sein müssen (auch wenn dies der Fall sein kann) . Stattdessen sind identische Bezugszeichen eher dahingehend zu verstehen, dass gleichartige (nicht notwendigerweise identische; auch wenn eine Identität gegeben sein kann) Funktionen von den betreffenden Bauteilen/Baugruppen erfüllt werden. Demzufolge ist in diesem Fall auch der Aufbau der betreffenden Bauteile/Baugruppen meist ähnlich.

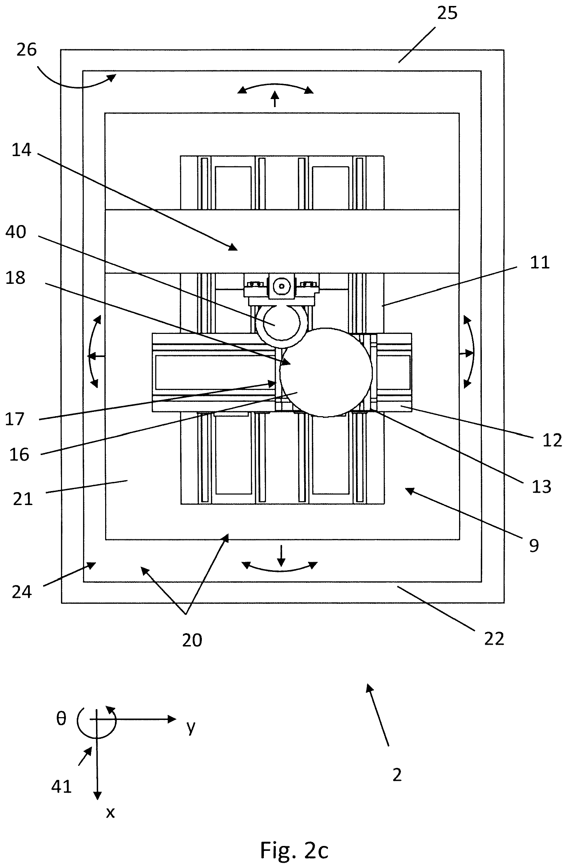

Auch beim vorliegend dargestellten Ausführungsbeispiel eines Prozessierungstischs 2 gemäss den Fig. 2a-2c wird ein annähernd handelsüblicher, mit gewissen Modifikationen versehener Positioniertisch 9 frei gleitend-verschieblich (einschliesslich verdrehbar) auf einer Oberseite 24 eines Basistischs 22 angeordnet. Im vorliegenden Ausführungsbeispiel sind die Luftkissenlager 30 teilweise in die Unterseite 23 des Sockels 21 eingelassen. Die freie Beweglichkeit (Verschiebbarkeit/Verdrehbarkeit) ist durch Pfeile in Fig. 2c angedeutet.

Wie auch der Positioniertisch 10 gemäss dem Ausführungsbeispiel in den Fig. 1a-1c, weist der vorliegend dargestellte Positioniertisch 9 eine stationäre Platte 11 auf, die auf dem Sockel 21 mechanisch starr befestigt ist. Auf der stationären Platte 11 ist in einer Translationsrichtung verschiebbar (x-Richtung; siehe das zur Übersicht eingezeichnete Koordinatensystem 41) und mittels entsprechender Aktuatoren verstellbar ein erster verfahrbarer Schlitten 12 angeordnet. Auf dem ersten verfahrbaren Schlitten 12 wiederum ist ein - ebenfalls mittels Aktuatoren in einer Translationsrichtung verschiebbar gelagerter - zweiter verfahrbarer Schlitten 13 angeordnet (y-Richtung). Auch bei dem in den Fig. 2a-2c dargestellten Prozessierungstisch 2 ist ein Drehtisch 17 vorgesehen, bei dem ein obenliegender Drehteller 16 mit Werkstückaufnahme 18 gegenüber einer Drehtischbasis 15 mittels Aktuator verdreht werden kann (θ-Richtung; siehe Koordinatensystem 41).

Zusätzlich ist beim vorliegend dargestellten Ausführungsbeispiel eines Prozessierungstischs 2 noch ein Doppelkeilsystem 19 vorgesehen. Das Doppelkeilsystem 19 ist zwischen Drehteller 16 und zweitem verfahrbaren Schlitten 13 vorgesehen. Ein oberer Keil 31 des Doppelkeilsystems 19 ist mit dem Drehtisch 17 (insbesondere der Drehtischbasis 15) verbunden, während ein unterer Keil 32 des Doppelkeilsystems 19 mit dem zweiten verfahrbaren Schlitten 13 verbunden ist. Durch eine Verschiebung der beiden Keile 31, 32 des Doppelkeilsystems 19 gegeneinander (unter Verwendung eines vorliegend nicht dargestellten Aktuators), kann die Höhe des Drehtischs 17 und damit der Werkstückaufnahme 18 des zu prozessierenden Werkstücks verändert werden (Verstellung in z-Richtung). Lediglich der Vollständigkeit halber wird darauf hingewiesen, dass eine Höhenverstellung in z-Richtung aufgrund der "Eigenheiten" des Doppelkeilsystems 19 auch eine Verschiebung in der x-y-Ebene mit sich bringt. Vorliegend ist das Doppelkeilsystem 19 so ausgerichtet, dass eine Höhenverstellung in z-Richtung als zusätzliche Komponente eine Verschiebung in γ-Richtung mit sich bringt. Diese Verschiebung in γ-Richtung kann jedoch ohne weiteres durch eine entsprechende "Korrektur" der Position des zweiten verfahrbaren Schlittens 13 ausgeglichen werden. Die Ansteuerelektronik muss hierzu lediglich geeignete Steuerbefehle an die ohnehin vorhandenen, betreffenden Aktuatoren senden.

Eine weitere Abweichung des vorliegend dargestellten Prozessierungstischs 2 vom in den Fig. 1a-1c dargestellten Prozessierungstisch 1 ist, dass die Oberseite 24 des Basistischs 22 vorliegend plan horizontal ausgebildet ist (also keine konkave Vertiefung aufweist). Um ein Herabrutschen des Positioniertischs 9 vom Basistisch 22 zu vermeiden, ist vorliegend ein Anschlagrahmen 25 im Bereich der äusseren Kanten der Oberseite 24 des Basistischs 22 vorgesehen. Auf den jeweiligen Innenseiten des Anschlagrahmens 25 ist jeweils ein Gummipolster 26 vorgesehen. Hierdurch greift die Anschlagvorrichtung vergleichsweise "weich" ein. Hierdurch werden Erschütterungen des Positioniertischs 9 vermieden. Wiederholte (insbesondere stärkere) Erschütterungen des Positioniertischs 9 können mit der Zeit zu einer Beschädigung von Teilen des Positioniertischs 9 bzw. zu einem Ausfall von Komponenten des Positioniertischs 9 führen. Darüber hinaus kann durch das weiche Eingreifen des Anschlagrahmens 25 mittels Gummipolster 26 gegebenenfalls auch ein Prozessierungsproblem des zu prozessierenden Werkstücks vermieden werden (beispielsweise fehlerhafte Bearbeitung aufgrund des Anschlagstosses), vor allem dann, wenn der Positioniertisch 9 bzw. der Sockel 21 des Positioniertischs 9 "gerade eben" (also mit geringer Restgeschwindigkeit) an den Anschlagrahmen 25 anstösst.

Selbstverständlich können zusätzlich (bzw. auch alternativ) zum vorliegend dargestellten Anschlagrahmen 25 auch noch Nullstellungsmittel vorgesehen werden, wie beispielsweise eine konkave Vertiefung, mechanische Federn mit geringen Federkräften und dergleichen.

## Patentansprüche

1. Werkstückpositionierungsanordnung (1, 2), aufweisend eine Positioniereinrichtung (9, 10) zum Positionieren eines Werkstücks sowie eine Entkopplungseinrichtung (20) zur entkoppelten Lagerung der Positioniereinrichtung (9, 10), wobei die Entkopplungseinrichtung ein Trägerelement (21), auf dem die Positioniereinrichtung (9, 10) angeordnet ist, und ein Basiselement (22), auf dem das Trägerelement (21) gelagert ist, aufweist, **dadurch gekennzeichnet, dass** das Trägerelement (21) zur Abkopplung von dynamischen Reaktionskräften der Positioniereinrichtung (9, 10) auf das Basiselement (22) zumindest bereichsweise frei gleitend beweglich, bevorzugt im Wesentlichen frei von Gegenkräften beweglich, auf dem Basiselement (22) gelagert ist.

2. Werkstückpositionierungsanordnung (1, 2) nach Anspruch 1, **dadurch gekennzeichnet, dass** das Trägerelement (21) mittels eines Fluidfilms, insbesondere mittels eines Flüssigkeitsfilms, eines Schmiermittelfilms, eines Ölfilms, eines Gasfilms und/oder eines Luftfilms auf dem Basiselement (22) gelagert ist.

3. Werkstückpositionierungsanordnung (1, 2) nach Anspruch 2, **dadurch gekennzeichnet, dass** zwischen dem Trägerelement (21) und dem Basiselement (22), vorzugsweise auf der dem Basiselement (22) zugewandten Seite (23) des Trägerelements (21) und/oder auf der dem Trägerelement (21) zugewandten Seite (24) des Basiselements (22), eine oder mehrere Fluidfilm-Lagerungseinrichtungen (30), insbesondere Luftkissen-Lagerungseinrichtungen (30), angeordnet sind.

4. Werkstückpositionierungsanordnung (1, 2) nach einem der vorangegangenen Ansprüche, **dadurch gekennzeichnet, dass** die Positioniereinrichtung (9, 10) einen stationären Teil (11) und wenigstens einen relativ zum stationären Teil (11) bewegbaren Teil (12, 13, 15, 16, 18, 19, 31, 32) aufweist, wobei bevorzugt das Verhältnis der Masse des wenigstens einen bewegbaren Teils (12, 13, 15, 16, 17, 18, 19, 31, 32) der Positioniereinrichtung (9, 10) zur Gesamtmasse des Trägerelements (21) und des stationären Teils (11) der Positioniereinrichtung (9, 10) wenigstens 1/5, insbesondere wenigstens 1/10, bevorzugt wenigstens 1/20, besonders bevorzugt wenigstens 1/25 beträgt.

5. Werkstückpositionierungsanordnung (1, 2) nach einem der vorangehenden Ansprüche, **dadurch gekennzeichnet, dass** die Positioniereinrichtung (9, 10) dazu eingerichtet ist, das Werkstück entlang wenigstens einer linearen Achse (x), insbesondere entlang wenigstens zweier linearen Achsen (x, y), bevorzugt entlang wenigstens dreier linearen Achsen (x, y, z), besonders bevorzugt entlang wenigstens dreier linearen Achsen (x, y, z) und um wenigstens eine Rotationsachse (θ) zu positionieren.

6. Werkstückpositionierungsanordnung (1, 2) nach einem der vorangehenden Ansprüche, insbesondere nach Anspruch 5, **dadurch gekennzeichnet, dass** das Trägerelement (21) in wenigstens einer horizontalen Richtung (x), insbesondere in wenigstens zwei vorzugsweise zueinander orthogonalen horizontalen Richtungen (x, y), bevorzugt in allen horizontalen Richtungen, über einen Bereich von wenigstens 3 cm, insbesondere wenigstens 5 cm, bevorzugt wenigstens 10 cm, besonders bevorzugt wenigstens 20 cm frei beweglich, bevorzugt im Wesentlichen frei von Gegenkräften, auf dem Basiselement (22) gelagert ist.

7. Werkstückpositionierungsanordnung (1, 2) nach einem der vorangehenden Ansprüche, **dadurch gekennzeichnet, dass** das Trägerelement (21) zumindest in einem Minimalbereich gegenüber dem Basiselement (22) frei beweglich ist, der sich aus einem maximalen Verfahrweg des wenigstens einen bewegbaren Teils (12, 13, 15, 16, 17, 18, 19, 31, 32) der Positioniereinrichtung (9, 10) und dem Verhältnis der Masse des wenigstens einen bewegbaren Teils (12, 13, 15, 16, 17, 18, 19, 31, 32) der Positioniereinrichtung (10) zur Gesamtmasse des Trägerelements (21) und des stationären Teils (11) der Positioniereinrichtung (9, 10) ergibt.

8. Werkstückpositionierungsanordnung (1, 2) nach einem der vorangehenden Ansprüche, **gekennzeichnet durch** wenigstens eine Begrenzungseinrichtung (25, 26) zur Begrenzung der freien Bewegbarkeit zwischen Basiselement (22) und Trägerelement (21).

9. Werkstückpositionierungsanordnung (1, 2) nach Anspruch 8, **dadurch gekennzeichnet, dass** die zumindest eine Begrenzungseinrichtung (25, 26) als weich eingreifende Begrenzungseinrichtung (26) ausgebildet ist und/oder die Begrenzungseinrichtung eine vorzugsweise weich eingreifende Anschlageinrichtung (26), insbesondere eine Federeinrichtung, eine Luftkisseneinrichtung und/oder eine Fluiddämpfungseinrichtung, aufweist, und/oder wenigstens eine in eine bevorzugt horizontale Richtung wirkende, besonders vorzugsweise weich eingreifende Feder aufweist, die zwischen Trägerelement (21) und Basiselement (22) angeordnet ist.

10. Werkstückpositionierungsanordnung (1, 2) nach einem der vorangehenden Ansprüche, **dadurch gekennzeichnet, dass** das Trägerelement (21) und/oder das Basiselement (22) als massiver Körper, insbesondere als Metallkörper, Eisenkörper, Gusseisenkörper, Mineralgusskörper, Stahlkörper, Steinblock, Marmorblock, Basaltblock und/oder Granitblock, ausgebildet ist.

11. Werkstückpositionierungsanordnung (1, 2) nach einem der vorangehenden Ansprüche, **dadurch gekennzeichnet, dass** das Basiselement (22) eine dem Trägerelement (21) zugewandte, vorzugsweise horizontal ausgerichtete Lagerungsfläche (24) aufweist.

12. Werkstückpositionierungsanordnung (1, 2) nach einem der vorangehenden Ansprüche, **gekennzeichnet durch** zumindest ein Nullstellungsmittel (24), das dazu ausgebildet und eingerichtet ist, insbesondere in einem Ruhezustand der Positioniereinrichtung (9, 10) das Trägerelement (21) in eine definierte Nullstellungsposition und/oder in einen definierten Nullstellungspositionsbereich gegenüber dem Basiselement (22) zu bringen.

13. Werkstückpositionierungsanordnung (1, 2) nach Anspruch 12, **dadurch gekennzeichnet, dass** das zumindest eine Nullstellungsmittel (24) als Federeinrichtung, als Schiefflächeneinrichtung (24) und/oder als aktiv ansteuerbare Aktuatoreinrichtung ausgebildet ist.

14. Werkstückpositionierungsanordnung (1, 2) nach einem der vorangehenden Ansprüche, **gekennzeichnet durch** zumindest eine Werkstückprozessierungseinrichtung (40), insbesondere zumindest eine Werkstückbearbeitungseinrichtung (40) und/oder zumindest eine Werkstückinspektionseinrichtung, die bevorzugt auf dem Trägerelement (21) angeordnet ist und insbesondere vorzugsweise starr mit diesem mechanisch gekoppelt ist.

15. Werkstückpositionierungsanordnung (1, 2) nach einem der vorangehenden Ansprüche, insbesondere nach Anspruch 14, **dadurch gekennzeichnet, dass** die Werkstückpositionierungsanordnung (1, 2) zur Prozessierung, Bearbeitung, Belichtung und/oder Inspektion von Halbleiterstrukturen, Mikrostrukturen, Nanostrukturen und/oder Wafern als Werkstück ausgebildet und eingerichtet ist.

## Claims

1. A workpiece positioning arrangement (1, 2), comprising a positioning device (9, 10) for positioning a workpiece as well as a decoupling device (20) for the decoupled storage of the positioning device (9, 10), wherein the decoupling device comprises a carrier element (21), on which the positioning device (9, 10) is arranged, and a base element (22), on which the carrier element (21) is supported, **characterized in that** for decoupling dynamic reaction forces of the positioning device (9, 10) on the base element (22) the carrier element (21) is supported on the base element (22) so as to move freely at least in a certain range, preferably essentially free of counterforces, in a sliding manner.

2. The workpiece positioning arrangement (1, 2) according to claim 1, **characterized in that** the carrier element (21) is supported on the base element (22) by means of a fluid film, in particular a liquid film, a lubricant film, an oil film, a gas film and/or an air film.

3. The workpiece positioning arrangement (1, 2) according to claim 2, **characterized in that** one or more fluid film storage devices (30), in particular air cushion storage devices (30), are arranged between the carrier element (21) and base element (22), preferably on the side (23) of the carrier element (21) facing the base element (22) and/or on the side (24) of the base element (22) facing the carrier element (21).

4. The workpiece positioning arrangement (1, 2) according to one of the preceding claims, **characterized in that** the positioning device (9, 10) comprises a stationary part (11) and at least one movable part (12, 13, 15, 16, 17, 18, 19, 31, 32) being movable relative to the stationary part (11), wherein the ratio between the mass of the at least one movable part (12, 13, 15, 16, 17, 18, 19, 31, 32) of the positioning device (9, 10) and the overall mass of the carrier element (21) and the stationary part (11) of the positioning device (9, 10) preferably measures at least 1/5, in particular at least 1/10, preferably at least 1/20, especially preferably at least 1/25.

5. The workpiece positioning arrangement (1, 2) according to one of the preceding claims, **characterized in that** the positioning device (9, 10) is configured to position the workpiece along at least one linear axis (x), in particular along at least two linear axes (x, y), preferably along at least three linear axes (x, y, z), especially preferably along at least three linear axes (x, y, z), and around at least one rotational axis (θ).

6. The workpiece positioning arrangement (1, 2) according to one of the preceding claims, in particular according to claim 5, **characterized in that** the carrier element (21) is supported on the base element (22) so as to move, in particular freely, preferably essentially free of counterforces, in at least a horizontal direction (x), in particular in at least two horizontal directions preferably orthogonal to each other (x, y), preferably in all horizontal directions, over a range of at least 3 cm, in particular at least 5 cm, preferably at least 10 cm, especially preferably at last 20 cm.

7. The workpiece positioning arrangement (1, 2) according to one of the preceding claims, **characterized in that** the carrier element (21) is movable, in particular freely movable, relative to the base element (22) in at least a minimal range, which is derived from a maximum traveling path of the at least one movable part (12, 13, 15, 16, 17, 18, 19, 31, 32) of the positioning device (9, 10), and from the ratio between the mass of the at least one movable part (12, 13, 15, 16, 17, 18, 19, 31, 32) of the positioning device (9, 10) and the overall mass of the carrier element (21) and stationary part (11) of the positioning device (9, 10).

8. The workpiece positioning arrangement (1, 2) according to one of the preceding claims, **characterized by** least one limiting device (25, 26) for limiting the free movability between the base element (22) and carrier element (21).

9. The workpiece positioning arrangement (1, 2) according to claim 8, **characterized in that** the at least one limiting device (25, 26) is configured as a preferably gently engaging limiting device (26), and/or that the limiting device comprises a preferably gently engaging stop device (26), in particular a spring device, an air cushion device and/or a fluid damping device, and/or comprises at least one preferably horizontally acting, especially preferably softly engaging spring, which is arranged between the carrier element (21) and base element (22).

10. The workpiece positioning arrangement (1, 2) according to one of the preceding claims, **characterized in that** the carrier element (21) and/or the base element (22) are constructed as a massive body, in particular as a metal body, iron body, cast iron body, mineral casting body, steel body, block of stone, block of marble, block of basalt and/or block of granite.

11. The workpiece positioning arrangement (1, 2) according to one of the preceding claims, **characterized in that** the base element (22) comprises a preferably horizontally aligned storage surface (24) facing the carrier element (21).

12. The workpiece positioning arrangement (1, 2) according to one of the preceding claims, **characterized by** at least one zero position means (24), which is configured and set up to bring the carrier element (21) into a defined zero position and/or into a defined zero position range relative to the base element (22), in particular in an idle state of the positioning device (9, 10).

13. The workpiece positioning arrangement (1, 2) according to claim 12, **characterized in that** the at least one zero position means (24) is configured as a spring device, a slanted surface device (24) and/or an actively activatable actuator device.

14. The workpiece positioning arrangement (1, 2) according to one of the preceding claims, **characterized by** a least one workpiece processing device (40), in particular at least one workpiece machining device (40) and/or at least one workpiece inspection device, which are preferably arranged on the carrier element (21), and in particular preferably fixedly mechanically coupled thereto.

15. The workpiece positioning arrangement (1, 2) according to one of the preceding claims, in particular according to claim 14, **characterized in that** the workpiece positioning arrangement (1, 2) is configured and set up for processing, machining, lighting and/or inspecting semiconductor structures, microstructures, nanostructures and/or wafers as a workpiece.

## Revendications

1. Agencement de positionnement d'une pièce à usiner (1, 2), comportant un système de positionnement (9, 10) destiné à positionner une pièce à usiner, ainsi qu'un système de désolidarisation (20) destiné au logement désolidarisé du système de positionnement (9, 10), le système de désolidarisation comportant un élément porteur (21) sur lequel est placé le système de positionnement (9, 10) et un élément de base (22), sur lequel est logé l'élément porteur (21), **caractérisé en ce que** pour désaccoupler des forces de réaction dynamiques exercées par le système de positionnement (9, 10) sur l'élément de base (22), l'élément porteur (21) est logé sur l'élément de base (22) en étant mobile au moins par endroits en coulissement libre, en étant mobile de préférence en étant sensiblement libre de forces antagonistes.

2. Agencement de positionnement d'une pièce à usiner (1, 2) selon la revendication 1, **caractérisé en ce que** l'élément porteur (21) est logé sur l'élément de base (22) au moyen d'un film de fluide, notamment au moyen d'un film de liquide, d'un film de lubrifiant, d'un film d'huile, d'un film de gaz et/ou d'un film d'air.

3. Agencement de positionnement d'une pièce à usiner (1, 2) selon la revendication 2, **caractérisé en ce qu'**entre l'élément porteur (21) et l'élément de base (22), de préférence sur le côté (23) de l'élément porteur (21) qui fait face à l'élément de base (22) et/ou sur le côté (24) de l'élément de base (22) qui fait face à l'élément porteur (21) sont placés un ou plusieurs systèmes de logement à film fluide (30), notamment des systèmes de logement à coussin d'air (30).

4. Agencement de positionnement d'une pièce à usiner (1, 2) selon l'une quelconque des revendications précédentes, **caractérisé en ce que** le système de positionnement (9, 10) comporte une partie stationnaire (11) et au moins une partie mobile (12, 13, 15, 16, 18, 19, 31, 32) par rapport à la partie stationnaire (11), le rapport de la masse de l'au moins une partie mobile (12, 13, 15, 16, 18, 19, 31, 32) du système de positionnement (9, 10) à la masse totale de l'élément porteur (21) et de la partie stationnaire (11) du système de positionnement (9, 10) s'élevant à au moins 1/5, notamment à au moins 1/10, de préférence à au moins 1/20, de manière particulièrement préférentielle à au moins 1/25.

5. Agencement de positionnement d'une pièce à usiner (1, 2) selon l'une quelconque des revendications précédentes, **caractérisé en ce que** le système de positionnement (9, 10) est aménagé pour positionner la pièce à usiner le long d'au moins un axe linéaire (x), notamment le long d'au moins deux axes linéaires (x, y), de préférence le long d'au moins trois axes linéaires (x, y, z), de manière particulièrement préférentielle le long d'au moins trois axes linéaires (x, y, z) et autour d'au moins un axe de rotation (θ).

6. Agencement de positionnement d'une pièce à usiner (1, 2) selon l'une quelconque des revendications précédentes, notamment selon la revendication 5, **caractérisé en ce que** l'élément porteur (21) est logé en étant librement mobile dans au moins une direction horizontale (x), notamment dans au moins deux directions horizontales (x, y) orthogonales l'une par rapport à l'autre, de préférence dans toutes les directions horizontales, sur une zone d'au moins 3 cm, notamment d'au moins 5 cm, de préférence d'au moins 10 cm, de manière particulièrement préférentielle d'au moins 20 cm, de préférence en étant sensiblement libre de forces antagonistes sur l'élément de base (22).

7. Agencement de positionnement d'une pièce à usiner (1, 2) selon l'une quelconque des revendications précédentes, **caractérisé en ce que** l'élément porteur (21) est librement mobile par rapport à l'élément de base (22) sur au moins une zone minimale qui résulte d'une course de déplacement maximale de l'au moins une partie mobile (12, 13, 15, 16, 17, 18, 19, 31, 32) du système de positionnement (9, 10) et du rapport de la masse de l'au moins une partie mobile (12, 13, 15, 16, 17, 18, 19, 31, 32) du système de positionnement (10) à la masse totale de l'élément porteur (21) et de la partie stationnaire (11) du système de positionnement (9, 10).

8. Agencement de positionnement d'une pièce à usiner (1, 2) selon l'une quelconque des revendications précédentes, **caractérisé par** au moins un système de limitation (25, 26) destiné à limiter la libre mobilité entre l'élément de base (22) et l'élément porteur (21).

9. Agencement de positionnement d'une pièce à usiner (1, 2) selon la revendication 8, **caractérisé en ce que** l'au moins un système de limitation (25, 26) est conçu sous la forme d'un système de limitation (26) à engagement souple et/ou **en ce que** le système de limitation comporte un système de butée (26) de préférence à engagement souple, notamment un système sur ressort, un système sur coussin d'air et/ou un système amortisseur fluide et/ou **en ce qu'**il comporte au moins un ressort, agissant dans une direction de préférence horizontale, de manière particulièrement préférentielle à engagement souple, qui est placé entre l'élément porteur (21) et l'élément de base (22).

10. Agencement de positionnement d'une pièce à usiner (1, 2) selon l'une quelconque des revendications précédentes, **caractérisé en ce que** l'élément porteur (21) et/ou l'élément de base (22) sont conçus sous la forme d'un corps massif, notamment d'un corps métallique, d'un corps en fer, d'un corps en fonte, d'un corps en fonte minérale, d'un corps en acier, d'un corps en pierre, d'un corps en marbre, d'un corps en basalte et/ou d'un corps en granit.

11. Agencement de positionnement d'une pièce à usiner (1, 2) selon l'une quelconque des revendications précédentes, **caractérisé en ce que** l'élément de base (22) comporte une surface de logement (24) qui fait face à l'élément porteur (21) orienté de préférence à l'horizontale.

12. Agencement de positionnement d'une pièce à usiner (1, 2) selon l'une quelconque des revendications précédentes, **caractérisé par** au moins un moyen de mise à zéro (24), qui est conçu et aménagé pour, notamment dans une position de repos du système de positionnement (9, 10) amener l'élément porteur (21) dans une position zéro définie et/ou dans une plage de position zéro définie par rapport à l'élément de base (22).

13. Agencement de positionnement d'une pièce à usiner (1, 2) selon la revendication 12, **caractérisé en ce que** l'au moins un moyen de mise à zéro (24) est conçu sous la forme d'un système sur ressort, d'un système à surfaces obliques (24) et/ou d'un système d'actionneur à amorçage actif.

14. Agencement de positionnement d'une pièce à usiner (1, 2) selon l'une quelconque des revendications précédentes, **caractérisé par** au moins un système de traitement de pièces à usiner (40), notamment un système d'usinage de pièces à usiner (40) et/ou par au moins un système d'inspection de pièces à usiner, qui est placé de préférence sur l'élément porteur (21) et qui est de préférence accouplé mécaniquement de manière rigide avec celui-ci.

15. Agencement de positionnement d'une pièce à usiner (1, 2), notamment selon la revendication 14, **caractérisé en ce que** l'agencement de positionnement d'une pièce à usiner (1, 2) est conçu et aménagé pour le traitement, l'usinage, l'exposition lumineuse et/ou l'inspection de structures à semi-conducteurs, de microstructures, de nanostructures et/ou de tranches de silicium en tant que pièces à usiner.
